# EUROPÄISCHE PATENTSCHRIFT

(11) **EP 3 123 494 B1**
(45) Veröffentlichungstag und Bekanntmachung des Hinweises auf die Patenterteilung: **17.07.2019**
(21) Anmeldenummer: 15713182.2
(22) Anmeldetag: 26.03.2015
(51) Int. Cl.: H01J 37/32

(54) **NIEDERDRUCKPLASMAANLAGE MIT SEQUENTIELLER STEUERUNG**
LOW-PRESSURE PLASMA SYSTEM WITH SEQUENTIAL CONTROL
INSTALLATION À PLASMA À BASSE PRESSION ET À COMMANDE SÉQUENTIELLE

(30) Priorität: 27.03.2014 DE 102014205695
(43) Veröffentlichungstag der Anmeldung: 01.02.2017
(73) Patentinhaber: Diener, Christof-Herbert, 72202 Nagold (DE)
(72) Erfinder: Diener, Christof-Herbert, 72202 Nagold (DE)
(74) Vertreter: Kohler Schmid Möbus Patentanwälte
(86) Internationale Anmeldenummer: PCT/EP2015/056636
(87) Internationale Veröffentlichungsnummer: WO 2015/144848

(56) Entgegenhaltungen:
- EP-A2- 0 180 373
- US-A- 4 313 783
- US-A- 4 700 315
- US-A1- 2005 039 680
- US-A1- 2013 240 144

## Beschreibung

Die Erfindung betrifft eine Niederdruckplasmaanlage mit einer zumindest teilweise evakuierbaren Behandlungskammer, einem Gaszuflussventil, einem Plasmagenerator und einer Steuerung, wobei die Steuerung einen Vakuumstromkreis, einen Gaszuflussstromkreis und einen Plasmastromkreis umfasst, wobei der Vakuumstromkreis eine an die Niederdruckplasmaanlage anschließbare Pumpe und/oder ein Pumpenventil der Niederdruckplasmaanlage, der Gaszuflussstromkreis das Gaszuflussventil und der Plasmastromkreis den Plasmagenerator steuert.

Derlei Niederdruckplasmaanlagen zur Behandlung eines Bauteils in einer teilweise evakuierbaren Behandlungskammer sind seit langer Zeit bekannt. Zur Behandlung des Bauteils wird das Bauteil in die Behandlungskammer gegeben. Anschließend wird die Behandlungskammer zumindest teilweise evakuiert. Hierzu ist eine Pumpe vorgesehen, die Teil der Niederdruckplasmaanlage oder eine externe Einheit sein kann. Die zumindest teilweise Evakuierung der Behandlungskammer kann durch Anschalten der Pumpe erfolgen. Alternativ oder zusätzlich dazu kann ein Pumpenventil zwischen Behandlungskammer und Pumpe geöffnet werden, um den Druck in der Behandlungskammer zu erniedrigen.

Die Behandlungskammer wird so lange abgepumpt, bis der gewünschte Druck erreicht ist. Anschließend wird über das Gaszuflussventil das gewünschte Prozessgas in die Behandlungskammer eingeleitet. Auch während der Gaseinleitung wird die Behandlungskammer weiter abgepumpt, so dass sich bei gleichbleibendem Gaszufluss ein Gleichgewicht zwischen dem abgepumpten Gas und dem zugeführten Gas einstellt. Nach dieser Stabilisierung der Gasdruckverhältnisse in der Behandlungskammer wird der Plasmagenerator angeschaltet, um ein Plasma in der Behandlungskammer zu entzünden. Die Behandlung des Bauteils erfolgt durch das gezündete Plasma. Bei dem Plasma kann es sich um eine Gleichspannungsplasma oder ein Wechselspannungsplasma handeln.

Es sind Plasmaanlagen bekannt, bei denen diese Prozessschritte vollautomatisch gesteuert werden. Die vollautomatischen Steuerungen umfassen in der Regel Mikrocontroller, Mikroprozessoren, FPGAs (field programmable gate arrays) und/oder speicherprogrammierbare Steuerungen. Nachteilig an den vollautomatischen Steuerungen ist jedoch, dass in der Regel Schütze eingesetzt werden müssen, um mit der Steuerung die hohen Versorgungsspannungen für die Niederdruckplasmaanlage, insbesondere den Plasmagenerator, zu schalten. Weiterhin müssen durch die vollautomatische Steuerung verschiedene Betriebsspannungen geschaltet werden. In der Regel müssen Einphasenwechselspannungen (z.B. 110 Volt und/oder 230 Volt) für die Pumpe, Dreiphasenwechselspannungen (z.B. 208 Volt und/oder 400 Volt) für den Plasmagenerator und Gleichspannung in Höhe von 24 Volt für Ventile und andere Kleinspannungsverbraucher der Niederdruckplasmaanlage bereitgestellt und durch die Steuerung geschaltet werden. Eine vollautomatische Steuerung ist daher entsprechend aufwändig und kostenintensiv.

Zum Beispiel offenbart EP 0 180 373 A2 die Steuerung einer Plasmaanlage mit einem Mikroprozessor.

US 2013/0240144 A1 offenbart ebenfalls eine Plasmaanlage mit einer Computersteuerung.

Alternativ zu einer vollautomatischen Steuerung ist es bekannt, verschiedene Komponenten der Niederdruckplasmaanlage einzeln durch mechanische Schalter, die von einem Benutzer betätigt werden, zu steuern. In diesem Fall ist ein Schalter für die Pumpe, ein Schalter für den Gaszufluss und ein Schalter für den Plasmagenerator vorgesehen.

Eine Plasmaanlage mit einem mechanischen Schalter ist in JP-S6064770 A offenbart.

In der Regel umfasst die Niederdruckplasmaanlage dabei noch weitere Schalter zum Steuern weiterer Komponenten. Eine Niederdruckplasmaanlage mit einer solchen Steuerung kann zwar einfach und kostengünstig ausgeführt werden, allerdings besteht die erhöhte Gefahr, dass ein Benutzer der Niederdruckplasmaanlage die mechanischen Schalter in der falschen Reihenfolge betätigt. Diese Gefahr besteht insbesondere bei ungelernten Benutzern der Niederdruckplasmaanlage. Wird beispielsweise die Behandlungskammer belüftet, so lange die Pumpe noch läuft, steigt der Ölverbrauch der Pumpe erheblich an. Weiterhin ist die Steuerung der Niederdruckplasmaanlage durch die Betätigung einzelner mechanischer Schalter unkomfortabel für den Benutzer.

Der vorliegenden Erfindung liegt daher die Aufgabe zugrunde, eine Niederdruckplasmaanlage bereitzustellen, die sowohl konstruktiv einfach und dadurch kostengünstig ausgebildet ist als auch eine intuitive und sichere Bedienung ermöglicht.

Diese Aufgabe wird durch eine Niederdruckplasmaanlage mit den Merkmalen des Anspruchs 1 gelöst. Die Unteransprüche geben zweckmäßige Weiterbildungen an.

Die eingangs beschriebene erfindungsgemäße Niederdruckplasmaanlage umfasst somit eine Steuerung mit einem sequentiellen Schaltelement mit aufeinander folgenden Schaltstellungen zur Einstellung aufeinander folgender Prozessschritte, wobei das sequentielle Schaltelement in jeder Schaltstellung durch mehrere voneinander elektrische isolierte Schalter zum jeweiligen Unterbrechen und Schließen des Vakuumstromkreises, des Gaszuflussstromkreises und des Plasmastromkreises ausgebildet ist, wobei das sequentielle Schaltelement eine erste Schaltstellung aufweist, in der der Vakuumstromkreis geschlossen ist, aber der Gaszuflussstromkreis und der Plasmastromkreis unterbrochen sind, wobei das sequentielle Schaltelement eine zweite Schaltstellung aufweist, in der der Vakuumstromkreis und der Gaszuflussstromkreis geschlossen sind, aber der Plasmastromkreis unterbrochen ist und wobei das Schaltelement eine dritte Schaltstellung aufweist, in der der Vakuumstromkreis, der Gaszuflussstromkreis und der Plasmastromkreis geschlossen sind.

Die Steuerung der Niederdruckplasmaanlage umfasst somit zumindest drei Stromkreise: einen Vakuumstromkreis zur Steuerung der Pumpe und/oder des Pumpenventils zur zumindest teilweisen Evakuierung der Behandlungskammer, einen Gaszuflussstromkreis zur Steuerung des Gaszuflussventils zum Einlass eines Prozessgases in die Behandlungskammer und einen Plasmastromkreis zur Steuerung eines Plasmagenerators, durch den ein Plasma in der Behandlungskammer zündbar ist. Der Vakuumstromkreis, der Gaszuflussstromkreis und der Plasmastromkreis sind durch das sequentielle Schaltelement steuerbar. Zur Steuerung des Vakuumstromkreises, des Gaszuflussstromkreises und des Plasmastromkreises weist das sequentielle Schaltelement jeweils mehrere Schalter auf, die nacheinander öffenbar und schließbar sind.

Durch die sequentielle Ausbildung des Schaltelements wird ein Benutzer der Niederdruckplasmaanlage gezwungen, die Prozessschritte in der durch das sequentielle Schaltelement vorgegebenen Reihenfolge zu durchlaufen. Die Bedienung der Niederdruckplasmaanlage ist dadurch sehr einfach. Der Benutzer muss lediglich das sequentielle Schaltelement schrittweise verstellen, um die Prozessschritte durchführen zu können. Durch die voneinander elektrisch isolierten Schalter können die verschiedenen Stromkreise ohne die Benutzung von Relais, Schützen oder dergleichen geschaltet werden. Weiterhin benötigt die Steuerung keine Software.

Mit anderen Worten können verschiedene Verbraucherspannungen (beispielsweise 24 Volt, 230 Volt und 400 Volt) über jeweils eigene Schalter des sequentiellen Schaltelements konstruktiv einfach und kostengünstig gesteuert werden. Die voneinander elektrisch isolierten Schalter können dabei als Schließer oder Öffner ausgebildet sein. Weiterhin kann ein Teil der Schalter als Öffner und ein Teil der Schalter als Schließer ausgebildet sein. Um die Steuerung besonders einfach auszubilden, werden vorzugsweise ausschließlich Schließer im sequentiellen Schaltelement zur Steuerung des Vakuumstromkreises, des Gaszuflussstromkreises und des Plasmastromkreises eingesetzt.

Die Steuerung der Niederdruckplasmaanlage kann einen Spülstromkreis mit einem Spülventil umfassen, um giftige Gase nach der Plasmabehandlung aus der Behandlungskammer herauszuspülen. In diesem Fall ist das sequentielle Schaltelement zum Unterbrechen und Schließen dessen Spülstromkreises ausgebildet, wobei das Schaltelement eine vierte Schaltstellung aufweist, in der der Vakuumstromkreis und der Spülstromkreis geschlossen sind, aber der Gaszuflussstromkreis und der Plasmastromkreis unterbrochen sind, wobei der Spülstromkreis in den Schaltstellungen 1 bis 3 unterbrochen ist. Die durch das sequentielle Schaltelement steuerbaren Prozessschritte sind dann:
1. Abpumpen durch Schließen des Vakuumstromkreises in Schaltstellung 1;
2. Prozessgaseinstellung durch zusätzliches Schließen des Gaszuflussstromkreises in Schaltstellung 2;
3. Plasmabehandlung durch zusätzliches Schließen des Plasmastromkreises in Schaltstellung 3; und
4. Spülen durch Schließen des Spülstromkreises und Öffnen des Gaszuflussstromkreises sowie des Plasmastromkreises in Schaltstellung 4.

In bevorzugter Ausgestaltung der Erfindung umfasst die Steuerung der Niederdruckplasmaanlage einen Belüftungsstromkreis mit einem Belüftungsventil, wobei das sequentielle Schaltelement zum Unterbrechen und Schließen des Belüftungsstromkreises ausgebildet ist, wobei das Schaltelement eine 5. Schaltstellung aufweist, in der der Belüftungsstromkreis geschlossen ist, aber der Vakuumstromkreis, der Gaszuflussstromkreis, der Plasmastromkreis, und insbesondere der Spülstromkreis, unterbrochen sind, wobei der Belüftungsstromkreis in den Schaltstellungen 1 bis 3, und insbesondere in der Schaltstellung 4, unterbrochen ist. Das sequentielle Schaltelement ist dadurch zum Schalten eines weiteren Prozessschrittes ausgebildet, in dem die Behandlungskammer durch ein Belüftungsventil belüftbar ist. Werden lediglich ungiftige Gase zur Plasmabehandlung verwendet, so kann sich die Belüftung unmittelbar an den Prozessschritt 3 (Plasmabehandlung) anschließen. Alternativ dazu kann sich der Prozessschritt Belüften an den Prozessschritt 4 (Spülen) anschließen.

Die Druckverhältnisse in der Behandlungskammer der Niederdruckplasmaanlage können durch eine Zeitmessung kontrolliert werden. Beispielsweise kann der Prozessschritt 1 (Abpumpen) für eine bestimmte Zeit durchgeführt werden, um sicherzustellen, dass ein gewünschter Basisdruck erzielt wird. Es ist daher nicht zwingend notwendig, ein Druckmessgerät in der Niederdruckplasmaanlage vorzusehen. Eine präzisere Steuerung der Niederdruckplasmaanlage kann jedoch durch einen Druckmessstromkreis mit einem Druckmessgerät erfolgen, wobei das sequentielle Schaltelement zum Unterbrechen und Schließen des Druckmessstromkreises ausgebildet ist, wobei der Druckmessstromkreis in den Schaltstellungen 1 bis 3, sowie insbesondere den Schaltstellungen 4 und/oder 5, geschlossen ist. Durch das Druckmessgerät kann der Benutzer den in der Behandlungskammer vorliegenden Druck präzise überwachen.

Der Benutzer kann das "Weiterschalten" des sequentiellen Schaltelements von der Druckanzeige des Druckmessgerätes abhängig machen. In einer bevorzugten Weiterbildung der Erfindung ist das Druckmessgerät demgegenüber dazu ausgebildet, ein erstes Freigabesignal an das Gaszuflussventil zu dessen Freigabe und/oder an den Plasmagenerator zu dessen Freigabe zu übermitteln. In diesem Fall kann verhindert werden, dass der nachfolgende Prozessschritt durchgeführt wird, wenn der Benutzer das sequentielle Schaltelement "zu früh" weiterschaltet, d.h. wenn eine "Weiterschaltung" erfolgt, ohne dass die notwendigen Gasdruckverhältnisse in der Behandlungskammer vorliegen. Hierdurch wird die Sicherheit und die Prozessstabilität der Niederdruckplasmaanlage maßgeblich erhöht.

Die Steuerung der Niederdruckplasmaanlage weist vorzugsweise einen Timerstromkreis mit einem Timer auf, wobei das sequentielle Schaltelement zum Unterbrechen und Schließen des Timerstromkreises ausgebildet ist, wobei der Timerstromkreis in der Schaltstellung 3 geschlossen ist. Der Timer kann zusätzlich dazu in der Schaltstellung 2 (Prozessgaseinstellung) geschlossen sein. Durch den Timer kann die Prozesszeit, d.h. die Plasmabehandlungszeit des Bauteils in der Behandlungskammer, gesteuert werden.

Die Steuerung kann weiterhin einen Heizungsstromkreis mit einer Heizung umfassen, wobei das sequentielle Schaltelement zum Unterbrechen und Schließen des Heizungsstromkreises ausgebildet ist, wobei der Heizungsstromkreis in der Schaltstellung 3 (Plasmabehandlung) geschlossen ist. Durch die Heizung kann das Bauteil während der Plasmabehandlung auf eine erhöhte Temperatur gebracht werden. Der Heizungsstromkreis kann in einer weiteren Schaltstellung oder in mehreren weiteren Schaltstellungen geschlossen sein, um eine Vorerwärmung oder Nacherwärmung des Bauteils zu ermöglichen.

Die Steuerung umfasst dabei vorzugsweise einen Temperaturmessstromkreis mit einem Temperaturmesselement, wobei das sequentielle Schaltelement zum Unterbrechen und Schließen des Temperaturmessstromkreises ausgebildet ist, wobei der Temperaturmessstromkreis in der Schaltstellung 3 geschlossen ist.

Der Temperaturmessstromkreis kann in einer oder mehreren weiteren Schaltstellungen geschlossen sein, um die Temperatur in der Behandlungskammer zu überwachen.

Die Bedienung der Niederdruckplasmaanlage kann weiter vereinfacht werden, wenn die Steuerung einen Netzteilstromkreis mit einem Netzteil der Niederdruckplasmaanlage umfasst, wobei das sequentielle Schaltelement zum Unterbrechen und Schließen des Netzteilstromkreises ausgebildet ist, wobei der Netzteilstromkreis in den Schaltstellungen 1 bis 3, sowie insbesondere in den Schaltstellungen 4 und/oder 5, geschlossen ist. Das Netzteil der Niederdruckplasmaanlage dient der Gesamtstromversorgung der Niederdruckplasmaanlage. Mit anderen Worten entspricht das Abschalten des Netzteils einem Abschalten der Niederdruckplasmaanlage durch einen "Hauptschalter". Somit wird die Bedienung der Niederdruckplasmaanlage vereinfacht, indem der sequentielle Schalter zusätzlich die Funktion des Hauptschalters übernimmt, wobei die Niederdruckplasmaanlage in einer Schaltstellung des sequentiellen Schaltelements vollständig abgeschaltet ist.

Eine umfassende Steuerung der Niederdruckplasmaanlage durch das sequentielle Schaltelement wird ermöglicht, wenn die Steuerung einen Pumpenstromkreis mit einem Pumpennetzteil umfasst, wobei das sequentielle Schaltelement zum Unterbrechen und Schließen des Pumpenstromkreises ausgebildet ist, wobei der Pumpenstromkreis in den Schaltstellungen 1 bis 3, sowie insbesondere in den Schaltstellungen 4 und/oder 5, geschlossen ist. Die elektrische Pumpe wird dabei über den Pumpenstromkreis mit Spannung versorgt. Ist der Pumpenstromkreis unterbrochen, so ist die Pumpe abgeschaltet. Mit anderen Worten wird die Pumpe durch das sequentielle Schaltelement ein- und ausgeschaltet.

Die Steuerung der Niederdruckplasmaanlage kann weiterhin einen Sicherheitsstromkreis mit einem Sicherheitsschalter, insbesondere einem Türschalter der Behandlungskammer, umfassen, wobei das sequentielle Schaltelement zum Unterbrechen und Schließen des Sicherheitsstromkreises ausgebildet ist, wobei der Sicherheitsstromkreis in den Schaltstellungen 1 bis 3, sowie insbesondere in den Schaltstellungen 4 und/oder 5, geschlossen ist. Der Sicherheitsstromkreis kann dabei zum Unterbrechen der in der Niederdruckplasmaanlage durchgeführten Prozesse ausgebildet sein. Insbesondere kann durch den Sicherheitsstromkreis eine Abschaltung des Gaszuflusses und des Plasmagenerators erzielt werden, wenn die Tür der Behandlungskammer geöffnet wird. Der Sicherheitsstromkreis dient insbesondere der Abschaltung des Plasmagenerators, um einen elektrischen Schlag bei einem Benutzer zu vermeiden. Der Sicherheitsstromkreis ist insbesondere vorteilhaft, wenn es sich bei der Behandlungskammer nicht um eine Glaskammer handelt.

Zur intuitiven Darstellung des jeweiligen Prozessschrittes kann der Vakuumstromkreis, der Gaszuflussstromkreis, der Plasmastromkreis, der Spülstromkreis und/oder der Belüftungsstromkreis eine Lampe, insbesondere eine Leuchtdiode, aufweisen. Die Lampe ist vorzugsweise im Bereich der jeweiligen Schaltstellung des sequentiellen Schaltelements an der dem Benutzer zugewandten Seite der Niederdruckplasmaanlage angeordnet. Durch die Lampe(n) sieht der Benutzer sofort, welche(r) Stromkreis(e) der Niederdruckplasmaanlage gerade geschlossen ist/sind, d.h. welche(r) Prozessschritt(e) durchgeführt wird/werden.

In besonders bevorzugter Ausgestaltung der Erfindung kann das sequentielle Schaltelement der Niederdruckplasmaanlage eine nullte Schaltstellung aufweisen, in der alle Stromkreise der Steuerung unterbrochen sind. Hierdurch muss kein separater "Ein- und Aus-Schalter" an der Niederdruckplasmaanlage vorgesehen werden. Vielmehr ist die Niederdruckplasmaanlage in diesem Fall durch das sequentielle Schaltelement selbst ein- und ausschaltbar.

Allgemein ist festzuhalten, dass das sequentielle Schaltelement dazu ausgebildet ist, in jeder Schaltstellung eine Mehrzahl voneinander elektrisch isolierter Schalter des sequentiellen Schaltelements zu schließen. Ein beliebiger Stromkreis der Steuerung ist dann in einer individuellen Schaltstellung des sequentiellen Schaltelements geschlossen, wenn er einen der Schalter dieser Schaltstellung kontaktiert. Demgegenüber ist ein Stromkreis in dieser Schaltstellung unterbrochen bzw. geöffnet, wenn er keinen Schalter dieser Schaltstellung kontaktiert. Das sequentielle Schaltelement kann beispielsweise in Form eines Schiebeschalters ausgebildet sein. In besonders bevorzugter Ausgestaltung des sequentiellen Schaltelements ist dieses jedoch in Form eines Drehschalters ausgebildet. Durch die Ausbildung des sequentiellen Schaltelements in Form eines Drehschalters befindet sich das sequentielle Schaltelement nach Durchlaufen eines vollständigen Prozesses automatisch wieder in der Ausgangsstellung. Der Drehschalter ist dabei vorzugsweise 6-stufig ausgebildet.

Der Drehschalter kann lediglich in eine Richtung drehbar ausgebildet sein, um eine Fehlbedienung der Niederdruckplasmaanlage vollständig auszuschließen. Alternativ dazu kann der Drehschalter in beide Richtungen drehbar sein. Dies ist besonders vorteilhaft, wenn die Steuerung einen Belüftungsstromkreis mit einem Belüftungsventil umfasst. In diesem Fall kann der Drehschalter durch Drehung in die "Gegenrichtung" in die Belüftungsstellung gebracht werden, um die Behandlungskammer zu belüften, ohne einen vollständigen Plasmabehandlungsprozess durchführen zu müssen.

Weitere Merkmale und Vorteile der Erfindung ergeben sich aus der nachfolgenden detaillierten Beschreibung eines Ausführungsbeispiels der Erfindung, anhand der Figuren der Zeichnung, die erfindungswesentliche Einzelheiten zeigt sowie aus den Ansprüchen.

Die in der Zeichnung dargestellten Merkmale sind derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

Es zeigen:
- Fig. 1a - 6a: Eine Draufsicht auf eine erfindungsgemäße Nieder-Druckplasmaanlage in den Schaltstellungen 0 - 5; und
- Fig. 1b - 6b: eine schematische Darstellung der Steuerung der Plasmaanlage gemäß den Figuren 1a - 6a in den Schaltstellungen 0 - 5.

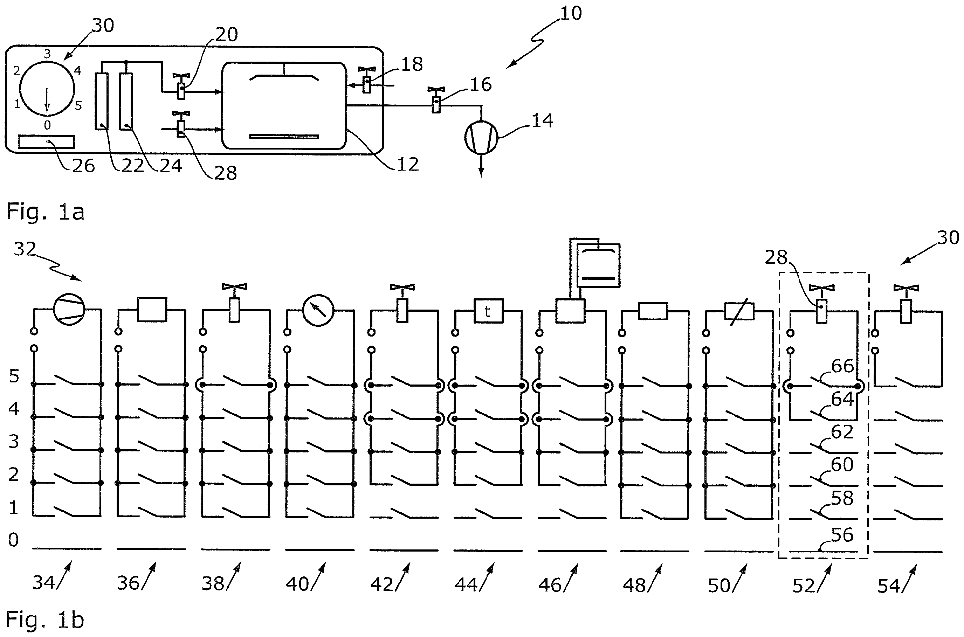

Figur 1a zeigt eine erfindungsgemäße Niederdruckplasmaanlage 10. Die Niederdruckplasmaanlage 10 ist stark schematisiert dargestellt. Sie weist eine Behandlungskammer 12 auf, die durch eine Pumpe 14 zumindest teilweise evakuierbar ist. Die Pumpe 14 ist über ein Pumpenventil 16 mit der Behandlungskammer 12 fluidisch verbunden. Die Behandlungskammer 12 kann somit bei angeschalteter Pumpe 14 und geöffnetem Pumpenventil 16 zumindest teilweise evakuiert werden. Das Pumpenventil 16 ist vorzugsweise in Form eines Eckventils ausgebildet.

Um die Behandlungskammer 12 zu belüften, ist ein Belüftungsventil 18 vorgesehen. In die Behandlungskammer 12 kann ein Prozessgas über ein Gaszuflussventil 20 eingelassen werden. Bei dem Prozessgas kann es sich um Umgebungsluft handeln. Alternativ oder zusätzlich dazu kann als Prozessgas ein oder mehrere Gase in die Behandlungskammer 12 eingelassen werden. Um verschiedene Gase in die Behandlungskammer 12 einzulassen, können mehrere Gaszuflussventile 20 vorgesehen sein. Im vorliegenden Fall ist lediglich ein Gaszuflussventil 20 vorgesehen, wobei an dem Gaszuflussventil 20 eine Gasmischung anliegt. Die Gasmischung wird über Gasflussmesser 22, 24 (Schwebekörper-Durchflussmesser mit Nadelventil oder Mass flow controller) eingestellt. Auf einer Druckanzeige 26 ist der Druck in der Behandlungskammer 12 anzeigbar. Zum Ausspülen giftiger Gase aus der Behandlungskammer 12 ist ein Spülventil 28 vorgesehen. Mit der Niederdruckplasmaanlage 10 können folgende Prozessschritte durchgeführt werden:
1. Abpumpen
2. Prozessgaseinstellung
3. Plasmabehandlung
4. Spülen
5. Belüften.

Die Niederdruckplasmaanlage 10 weist ein sequentielles Schaltelement 30 zur Einstellung dieser Prozessschritte mittels entsprechender Schaltstellungen auf. In Figur 1a ist die Schaltstellung null an dem sequentiellen Schaltelement 30 eingestellt. In dieser Schaltstellung ist die Niederdruckplasmaanlage 10 ausgeschaltet.

Figur 1b zeigt in schematischer Ansicht eine Steuerung 32 der Niederdruckplasmaanlage 10 gemäß Figur 1a in der Schaltstellung null. Die Steuerung 32 umfasst im Wesentlichen das sequentielle Schaltelement 30, dessen Schaltstellungen (von 0 bis 5) auf der linken Seite von Figur 1b dargestellt sind. Das sequentielle Schaltelement 30 umfasst einen Pumpenstromkreis 34, einen Netzteilstromkreis 36, einen Vakuumstromkreis 38, einen Druckmessstromkreis 40, einen Gaszuflussstromkreis 42, einen Timerstromkreis 44, einen Plasmastromkreis 46, einen Heizungsstromkreis 48, einen Temperaturmessstromkreis 50, einen Spülstromkreis 52 und einen Belüftungsstromkreis 54. Bei den Stromkreisen 34, 36, 38, 40, 42, 44, 46, 48, 50, 52, 54 handelt es sich um elektrische Stromkreise. Das sequentielle Schaltelement 30 kann weiterhin einen Sicherheitsstromkreis (nicht gezeigt) umfassen, insbesondere um eine Überwachung einer Tür der Behandlungskammer 12 (siehe Figur 1a) zu ermöglichen.

Wie aus Figur 1b ersichtlich ist, weist das sequentielle Schaltelement 30 für jede Schaltstellung (0 bis 5) jeweils einen Schalter zur Steuerung der Stromkreise 34, 36, 38, 40, 42, 44, 46, 48, 50, 52, 54 auf. Soll ein Stromkreis 34, 36, 38, 40, 42, 44, 46, 48, 50, 52, 54 in der jeweiligen Schaltstellung (0 bis 5) geschlossen sein, so wird der jeweilige Schalter des sequentiellen Schaltelements 30 in dieser Schaltstellung (0 - 5) kontaktiert. Dies wird nachfolgend exemplarisch für den Spülstromkreis 52 erläutert, der in Fig. 1b gestrichelt eingerahmt dargestellt ist:
Der Spülstromkreis 52 weist eine Spannungsquelle auf, die durch zwei ungefüllte Kreise dargestellt ist. Von einem ersten Anschluss der Spannungsquelle fließt der Strom über den Verbraucher (hier das Spülventil 28 über einen oder mehrere geschlossene Schalter zurück zum zweiten Anschluss der Spannungsquelle. Der Spülstromkreis 52 weist für die Schaltstellungen 0 bis 5 des sequentiellen Schaltelements 30 jeweils einen Schalter 56, 58, 60, 62, 64, 66 auf. Die geöffneten Schalter sind dabei mit in der Mitte abgewinkeltem Strich dargestellt (siehe Schalter 58, 60, 62, 64, 66) und die geschlossenen Schalter mit in der Mitte durchgehendem Strich (siehe Schalter 56).

Das Spülventil 28 soll nur in der Schaltstellung 4 geschlossen und in allen anderen Schaltstellungen (0 -3 und 5) geöffnet sein. Daher ist im Spülstromkreis 52 lediglich der Schalter 64, der in Schaltstellung 4 betätigt wird, kontaktiert. Alle anderen Schalter 56, 58, 60, 62, 66 sind im Spülstromkreis 52 nicht kontaktiert. Die "Nichtkontaktierung" des Schalters 66 ist dabei durch "höckerförmige Halbkreise" der Stromkreisleitungen um den Schalter 66 dargestellt.

Die vorgenannten Erläuterungen gelten entsprechend für die anderen Stromkreise 34, 36, 38, 40, 42, 44, 46, 48, 50 und 54.

Die voneinander elektrisch isolierten Schalter des sequentiellen Schaltelements 30 zur Ausbildung der Steuerung 32 sind dabei wie folgt kontaktiert:
a) Der Vakuumstromkreis 38 kontaktiert erste Schalter der Schaltstellungen 1, 2 und 3, die den Prozessschritten Abpumpen, Prozessgaseinstellung und Plasmabehandlung entsprechen. Vorzugsweise kontaktiert der Vakuumstromkreis 38 weiterhin erste Schalter der Schaltstellungen 4 und/oder 5, die den Prozessschritten Spülen und Belüften entsprechen.
b) Der Gaszuflussstromkreis 42 kontaktiert zweite Schalter der Schaltstellungen 2 und 3, die den Prozessschritten Prozessgaseinstellung und Plasmabehandlung entsprechen.
c) Der Plasmastromkreis 46 kontaktiert einen dritten Schalter der Schaltstellung 3, die dem Prozessschritt Plasmabehandlung entspricht.
d) Der vorzugsweise vorgesehene Spülstromkreis 52 kontaktiert einen vierten Schalter der Schaltstellung 4, die dem Prozessschritt Spülen entspricht.
e) Der vorzugsweise vorgesehene Belüftungsstromkreis 54 kontaktiert einen fünften Schalter der Schaltstellung 5, die dem Prozessschritt Belüften entspricht.
f) Der vorzugsweise vorgesehene Druckmessstromkreis 40 kontaktiert sechste Schalter der Schaltstellungen 1, 2 und 3, die den Prozessschritten Abpumpen, Prozessgaseinstellung und Plasmabehandlung entsprechen.
   Vorzugsweise kontaktiert der Druckmessstromkreis 40 weiterhin sechste Schalter der Schaltstellungen 4 und/oder 5, die den Prozessschritten Spülen und Belüften entsprechen.
g) Der vorzugsweise vorgesehene Timerstromkreis 44 kontaktiert einen siebten Schalter der Schaltstellung 3, die dem Prozessschritt Plasmabehandlung entspricht.
h) Der vorzugsweise vorgesehene Heizungsstromkreis 48 kontaktiert achte Schalter der Schaltstellungen 1, 2 und 3, die den Prozessschritten Abpumpen, Prozessgaseinstellung und Plasmabehandlung entsprechen.
   Vorzugsweise kontaktiert der Heizstromkreis 48 weiterhin achte Schalter der Schaltstellungen 4 und/oder 5, die den Prozessschritten Spülen und Belüften entsprechen.
i) Der vorzugsweise vorgesehene Temperaturmessstromkreis 50 kontaktiert neunte Schalter der Schaltstellungen 1, 2 und 3, die den Prozessschritten Abpumpen, Prozessgaseinstellung und Plasmabehandlung entsprechen.
   Vorzugsweise kontaktiert der Temperaturmessstromkreis 50 weiterhin neunte Schalter der Schaltstellungen 4 und/oder 5, die den Prozessschritten Spülen und Belüften entsprechen.
j) Der vorzugsweise vorgesehene Pumpenstromkreis 34 kontaktiert zehnte Schalter der Schaltstellungen 1, 2 und 3, die den Prozessschritten Abpumpen, Prozessgaseinstellung und Plasmabehandlung entsprechen.
   Vorzugsweise kontaktiert der Pumpenstromkreis 34 weiterhin zehnte Schalter der Schaltstellungen 4 und/oder 5, die den Prozessschritten Spülen und Belüften entsprechen.
k) Der vorzugsweise vorgesehene Netzteilstromkreis 36 kontaktiert elfte Schalter der Schaltstellungen 1, 2 und 3, die den Prozessschritten Abpumpen, Prozessgaseinstellung und Plasmabehandlung entsprechen.
   Vorzugsweise kontaktiert der Netzteilstromkreis 36 weiterhin elfte Schalter der Schaltstellungen 4 und/oder 5, die den Prozessschritten Spülen und Belüften entsprechen.

In Figur 1b befindet sich das sequentielle Schaltelement 30 in Schaltstellung 0 (vgl. auch Figur 1a). Alle Schalter der Schaltstellung 0, beispielsweise der Schalter 56 des Spülstromkreises 52, sind geschlossen. Da jedoch keiner der Stromkreise 34, 36, 38, 40, 42, 44, 46, 48, 50, 52, 54 die Schalter der Schaltstellung 0 kontaktiert, sind alle Stromkreise 34, 36, 38, 40, 42, 44, 46, 48, 50, 52, 54 in der Schaltstellung 0 geöffnet. In der Schaltstellung 0 ist somit die Niederdruckplasmaanlage 10 (siehe Figur 1a) ausgeschaltet.

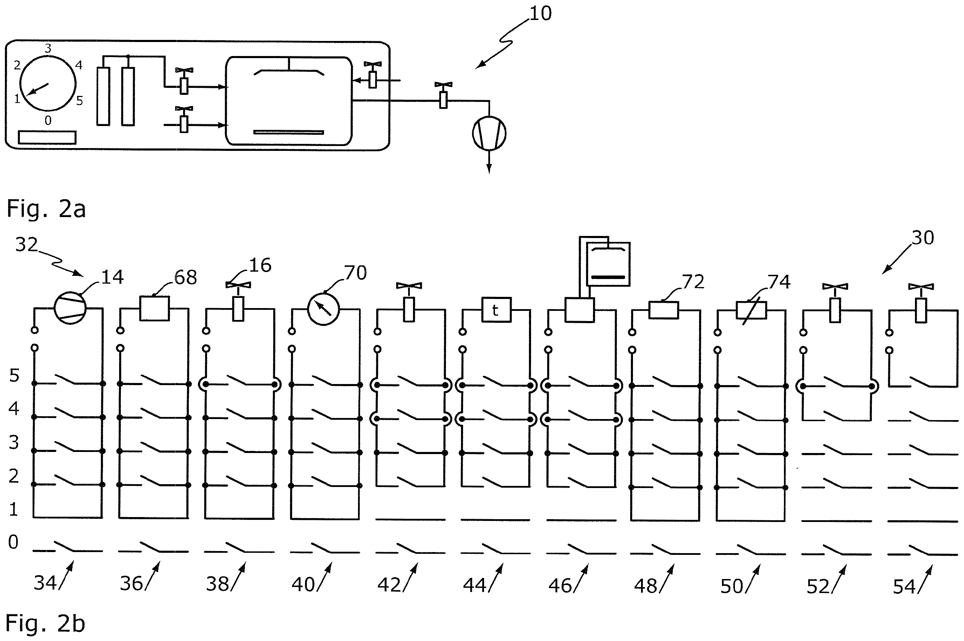

Figur 2a zeigt die Niederdruckplasmaanlage 10 in der Schaltstellung 1. Figur 2b zeigt die Steuerung 32 der Niederdruckplasmaanlage 10 (siehe Figur 2a) in dieser Schaltstellung 1. Die Schaltkreise 34, 36, 38, 40, 42, 44, 46, 48, 50, 52, 54 sind so geschaltet, dass der Pumpenschaltkreis 34 der Netzteilschaltkreis 36, der Vakuumschaltkreis 38, der Druckmessschaltkreis 40 sowie der Heizungsschaltkreis 48 und der Temperaturmesskreis 50 geschlossen sind.

Der Gaszuflussschaltkreis 42, der Timerschaltkreis 44, der Plasmaschaltkreis 46 sowie der Spülstromkreis 52 und der Belüftungsstromkreis 54 sind geöffnet. Hierdurch sind in der gezeigten Schaltstellung 1 die Pumpe 14, ein Netzteil 68 der Niederdruckplasmaanlage 10 (siehe Figur 2a) ein Pumpenventil 16, ein Druckmessgerät 70, eine Heizung 72 sowie ein Temperaturmesselement 74 aktiv. Die Pumpe 14 wird dabei durch ein Pumpennetzteil (nicht gezeigt) aktiviert.

Das Netzteil 68 versorgt die Niederdruckplasmaanlage 10 mit Spannung, insbesondere mit einer Steuerspannung (z.B. 24 Volt Gleichspannung). Das Druckmessgerät 70 ist mit der Druckanzeige 25 (siehe Figur 1a) verbunden, um den durch das Druckmessgerät 70 gemessenen Druck anzuzeigen. Durch die Heizung 72 wird ein in die Behandlungskammer 12 (siehe Figur 1a) eingebrachtes Bauteil bzw. eine Probe erwärmt. Die Temperatur wird durch das Temperaturmesselement 74 überwacht. Die Schaltstellung 1 des sequentiellen Schaltelements 30 entspricht somit dem Prozessschritt "Abpumpen" in dem die Behandlungskammer 12 (siehe Figur 1a) zumindest teilweise evakuiert und durch die Heizung 72 erwärmt wird. Der Druck in der Behandlungskammer 12 wird auf der Druckanzeige 26 (siehe Figur 1a) angezeigt.

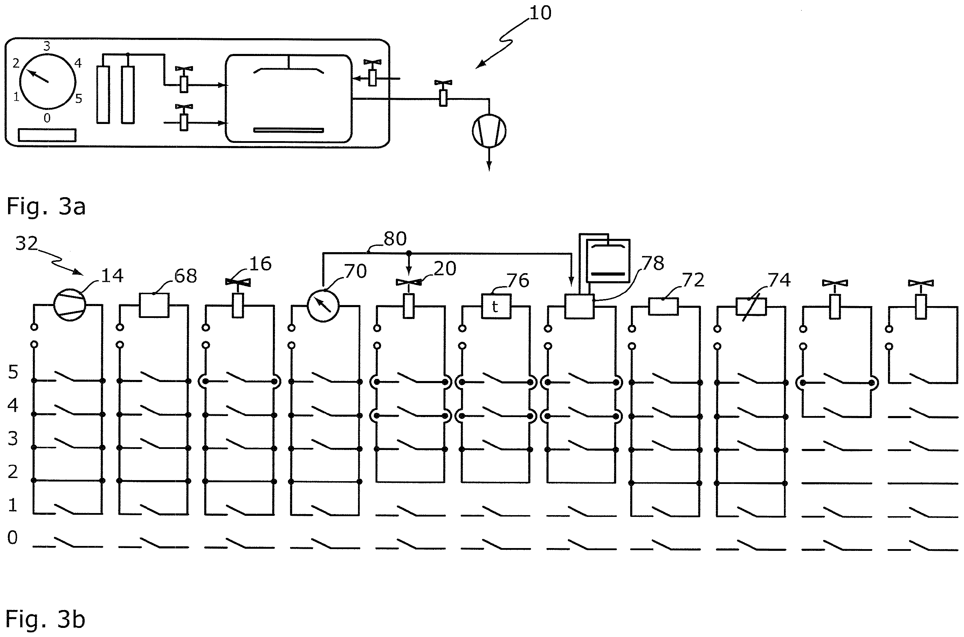

Figur 3a zeigt die Niederdruckplasmaanlage 10 in Schaltstellung 2. Schaltstellung 2 entspricht dem Prozessschritt "Prozessgaseinstellung".

Figur 3b zeigt die Steuerung 32 in dieser Schaltstellung 2. In dieser Schaltstellung 2 sind die Pumpe 14, das Netzteil 68, das Pumpenventil 16, das Druckmessgerät 70, die Heizung 72 sowie das Temperaturmesselement 74 aktiviert. Zusätzlich dazu sind das Gaszuflussventil 20, ein Timer 76 und ein Plasmagenerator 78 aktiviert.

Das Druckmessgerät 70 ist dazu ausgebildet ein erstes Freigabesignal an das Gaszuflussventil 20 und den Plasmagenerator 78 zu deren Freigabe zu übermitteln. Dieses erste Freigabesignal ist in Figur 2b durch einen ersten Pfeil 80 symbolisiert. Das Gaszuflussventil 20 wird dadurch erst geöffnet, wenn die Öffnung durch das erste Freigabesignal des Druckmessgeräts 70 erfolgt. Mit anderen Worten erfolgt der Gaszufluss in die Behandlungskammer 12 (siehe Figur 1a) erst dann, wenn das Druckmessgerät 70 den Gaszufluss über das erste Freigabesignal nach Erreichen eines gewünschten und eingestellten Basisdrucks gemessen hat. Das erste Freigabesignal (siehe Pfeil 80) gibt zwar auch den Plasmagenerator 78 frei, das Plasma wird jedoch erst gezündet, wenn auch der Timer 76 seine Freigabe gegeben hat. Dies ist während der Prozessgaseinstellung noch nicht der Fall.

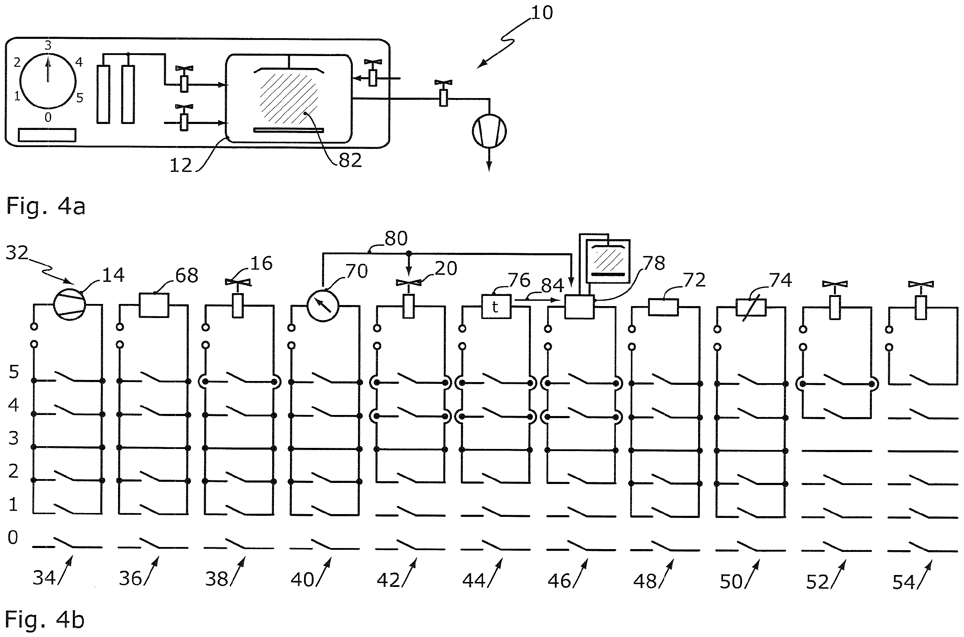

Figur 4a zeigt die Niederdruckplasmaanlage 10 in der Schaltstellung 3. Die Schaltstellung 3 entspricht dem Prozessschritt "Plasmabehandlung". In dieser Schaltstellung 3 ist ein Plasma 82 in der Behandlungskammer 12 gezündet. In dieser Schaltstellung erfolgt die "eigentliche" Behandlung eines in die Behandlungskammer 12 eingebrachten Bauteils.

Figur 4b zeigt die Steuerung 32 in der Schaltstellung 3. Der Pumpenstromkreis 34, der Netzteilstromkreis 36, der Vakuumstromkreis 38, der Druckmessstromkreis 40, der Gaszuflussstromkreis 42, der Timerstromkreis 44, der Plasmastromkreis 46, der Heizungsstromkreis 48 sowie der Temperaturmessstromkreis 50 sind geschlossen. Lediglich der Spülstromkreis 52 und der Belüftungsstromkreis 54 sind geöffnet bzw. unterbrochen. Hierdurch sind die Pumpe 14, das Netzteil 68, das Pumpenventil 16, das Druckmessgerät 70, das Gaszuflussventil 20, der Timer 76, der Plasmagenerator 78, die Heizung 72 sowie das Temperaturmesselement 74 aktiviert. Ein erstes Freigabesignal (symbolisiert durch einen ersten Pfeil 80) gibt das Gaszuflussventil 20 sowie den Plasmagenerator 78 frei. Zusätzlich dazu gibt der Timer 76 den Plasmagenerator 78 durch ein zweites Freigabesignal (symbolisiert durch einen zweiten Pfeil 84) frei.

Erst bei Vorliegen beider Freigabesignale wird der Plasmagenerator 78 aktiviert. Der Timer 76 gibt den Plasmagenerator 78 dabei nur während einer voreingestellter Freigabezeit frei. Hierdurch wird sichergestellt, dass die Behandlungszeit eine in den Timer 76 eingegebene Behandlungszeit nicht übersteigt.

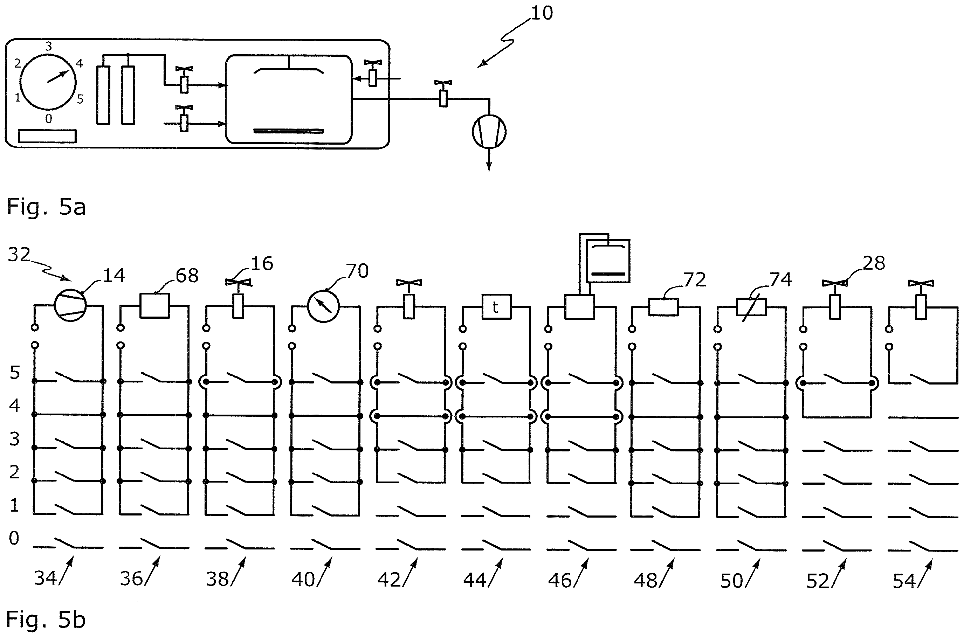

Figur 5a zeigt die Niederdruckplasmaanlage 10 in Schaltstellung 4. Die Schaltstellung 4 entspricht dem Prozessschritt "Spülen".

Figur 5b zeigt die Steuerung 32 in dieser Schaltstellung 4. Die Stromkreise 34, 36, 38, 40, 42, 44, 46, 48, 50, 52, 54 sind derart ausgebildet, dass in Schaltstellung 4 die Pumpe 14 das Netzteil 68, das Pumpenventil 16, das Druckmessgerät 70, die Heizung 72, das Temperaturmesselement 74 sowie das Spülventil 28 aktiviert sind. In Schaltstellung 4, d.h. während des Prozessschrittes "Spülen", wird somit die Behandlungskammer 12 (siehe Figur 1a) gespült, indem gleichzeitig Spülgas über das Spülventil 28 in die Behandlungskammer 12 einströmt und die Behandlungskammer 12 über das Pumpenventil 16, und die Pumpe 14 abgepumpt wird.

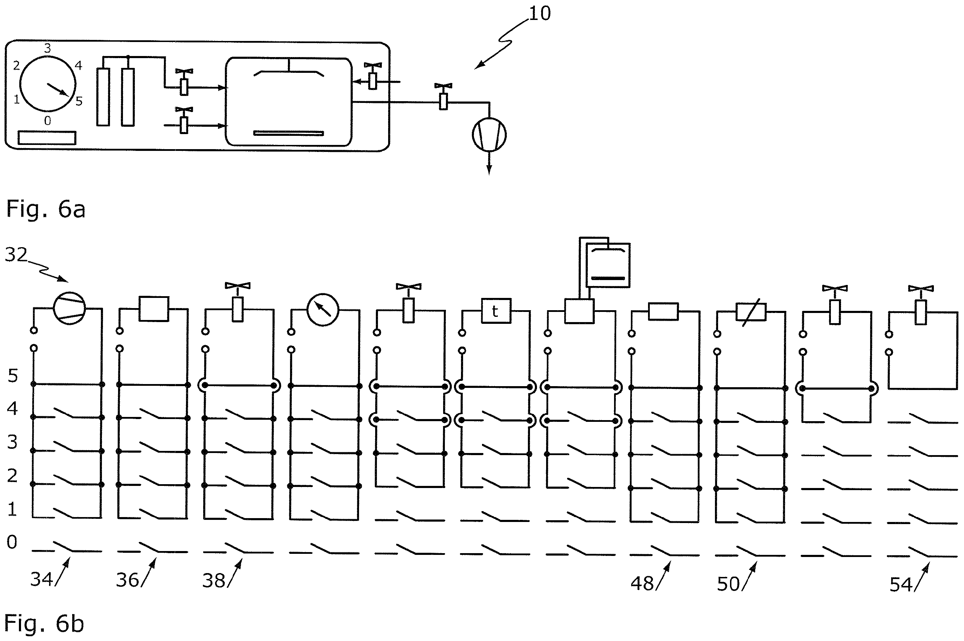

Figur 6a zeigt die Niederdruckplasmaanlage 10 in Schaltstellung 5. Schaltstellung 5 entspricht dem Prozessschritt "Belüften".

Figur 6b zeigt die Steuerung 32 in dieser Schaltstellung 5. In dieser Schaltstellung 5 sind der Netzteilstromkreis 36, der Heizungsstromkreis 48 sowie der Temperaturmessstromkreis 50 geschlossen. Einer oder mehrere dieser Stromkreise könnten jedoch auch in der Schaltstellung 5 geöffnet sein. Weiterhin ist der Pumpenstromkreis 34 geschlossen. Die Behandlungskammer 12 (siehe Figur 1a) wird jedoch nicht evakuiert, da der Vakuumstromkreis 38 geöffnet ist. Der Pumpenstromkreis 34 könnte in dieser Schaltstellung auch geöffnet sein. Schließlich ist der Belüftungsstromkreis 54 geschlossen, so dass die Behandlungskammer 12 (siehe Figur 1a) belüftet wird.

Dreht der Benutzer das sequentielle Schaltelement 30 noch eine Schaltstellung weiter, so befindet sich die Niederdruckplasmaanlage 10 wieder im abgeschalteten Zustand (siehe Figur 1a). Der Benutzer kann somit das sequentielle Schaltelement 30 eine Umdrehung im Uhrzeigersinn drehen, um einen kompletten Behandlungsprozess für ein Bauteil zu durchlaufen. Dies ermöglicht eine besonders einfache und sichere Bedienung der Niederdruckplasmaanlage 10.

Zusammenfassend betrifft die Erfindung eine Niederdruckplasmaanlage. Die Niederdruckplasmaanlage weist eine Behandlungskammer auf. Die Behandlungskammer wird in einem ersten Prozessschritt, dem Abpumpen, durch eine Pumpe abgepumpt. In einem zweiten Prozessschritt, der Prozessgaseinstellung, wird zusätzlich ein Gaszuflussventil geöffnet, um in der Behandlungskammer eine definierte Gaszusammensetzung bei niedrigem Druck zu erzielen. In einem dritten Prozessschritt, der Plasmabehandlung, wird ein Plasmagenerator angeschaltet, um ein Plasma in der Behandlungskammer zu zünden. In einem vierten Prozessschritt dem Spülen, kann ein Spülventil geöffnet werden, um die Behandlungskammer zu spülen. In diesem Prozessschritt sind das Gaszuflussventil geschlossen und der Plasmagenerator abgeschaltet. In einem fünften Prozessschritt, dem Belüften, kann die Behandlungskammer über ein Belüftungsventil belüftet werden. Den Prozessschritten entsprechen Schaltstellungen eines sequentiellen Schaltelements, vorzugsweise in Form eines Drehschalters. Das sequentielle Schaltelement kann eine nullte Schaltstellung aufweisen, in der die Niederdruckplasmaanlage abgeschaltet ist. Das sequentielle Schaltelement ermöglicht eine einfache Ausbildung der Niederdruckplasmaanlage sowie deren intuitive Bedienung.

Das sequentielle Schaltelement ist durch einen Benutzer der Niederdruckplasmaanlage schrittweise in die aufeinander folgenden Schaltstellungen betätigbar. Die Niederdruckplasmaanlage ist dabei ohne einen, insbesondere elektrischen, Antrieb zur Betätigung des sequentiellen Schaltelements ausgebildet. Mit anderen Worten ist die Niederdruckplasmaanlage derart ausgebildet, dass die aufeinander folgenden Schaltstellungen des sequentiellen Schaltelements ausschließlich durch einen Benutzer der Niederdruckplasmaanlage, nicht aber durch die Niederdruckplasmaanlage selbst, einstellbar sind.

## Patentansprüche

1. Niederdruckplasmaanlage (10) mit einer zumindest teilweise evakuierbaren Behandlungskammer (12), einem Gaszuflussventil (20), einem Plasmagenerator (78) und einer Steuerung (32),
wobei die Steuerung (32) einen Vakuumstromkreis (38), einen Gaszuflussstromkreis (42) und einen Plasmastromkreis (46) umfasst,
wobei der Vakuumstromkreis (38) eine an die Niederdruckplasmaanlage (10) anschließbare Pumpe (14) und/oder ein Pumpenventil (38) der Niederdruckplasmaanlage (10), der Gaszuflussstromkreis (42) das Gaszuflussventil (20) und der Plasmastromkreis (46) den Plasmagenerator (78) steuert, wobei die Steuerung (32) ein sequentielles Schaltelement (30) mit aufeinander folgenden Schaltstellungen zur Einstellung aufeinander folgender Prozessschritte umfasst,
wobei das sequentielle Schaltelement (30) in jeder Schaltstellung durch mehrere voneinander elektrisch isolierte Schalter (56, 58, 60, 62, 64, 66) zum jeweiligen Unterbrechen und Schließen des Vakuumstromkreises (38), des Gaszuflussstromkreises (42) und des Plasmastromkreises (46) ausgebildet ist,
wobei das sequentielle Schaltelement (30) eine erste Schaltstellung aufweist, in der der Vakuumstromkreis (38) geschlossen ist, aber der Gaszuflussstromkreis (42) und der Plasmastromkreis (46) unterbrochen sind,
wobei das sequentielle Schaltelement (30) eine zweite Schaltstellung aufweist, in der der Vakuumstromkreis (38) und der Gaszuflussstromkreis (42) geschlossen sind, aber der Plasmastromkreis (46) unterbrochen ist,
wobei das sequentielle Schaltelement (30) eine dritte Schaltstellung aufweist, in der der Vakuumstromkreis (38), der Gaszuflussstromkreis (42) und der Plasmastromkreis (46) geschlossen sind, wobei das sequentielle Schaltelement (30) zur Steuerung des Vakuumstromkreises (38), des Gasflussstromkreises (42) und des Plasmastromkreises (46) jeweils mehrere Schalter (56, 58, 60, 62, 64, 66) aufweist, die nacheinander öffenbar und schließbar sind, und wobei das sequentielle Schaltelement (30) dazu ausgebildet ist, in jeder Schaltstellung eine Mehrzahl voneinander elektrisch isolierter Schalter (56, 58, 60, 62, 64, 66) des sequentiellen Schaltelements (30) zu schließen.

2. Niederdruckplasmaanlage nach Anspruch 1, bei der die Steuerung (32) einen Spülstromkreis (52) mit einem Spülventil (28) umfasst, wobei das sequentielle Schaltelement (30) zum Unterbrechen und Schließen des Spülstromkreises (52) ausgebildet ist,
wobei das sequentielle Schaltelement (30) eine vierte Schaltstellung aufweist, in der der Vakuumstromkreis (38) und der Spülstromkreis (52) geschlossen sind, aber der Gaszuflussstromkreis (42) und der Plasmastromkreis (46) unterbrochen sind, wobei der Spülstromkreis (52) in den Schaltstellungen 1 bis 3 unterbrochen ist.

3. Niederdruckplasmaanlage nach Anspruch 1 oder 2, bei der die Steuerung (32) einen Belüftungsstromkreis (54) mit einem Belüftungsventil (18) umfasst, wobei das sequentielle Schaltelement (30) zum Unterbrechen und Schließen des Belüftungsstromkreises (54) ausgebildet ist, wobei das sequentielle Schaltelement (30) eine fünfte Schaltstellung aufweist, in der der Belüftungsstromkreis (54) geschlossen ist, aber der Vakuumstromkreis (38), der Gaszuflussstromkreis (42) und der Plasmastromkreis (46) unterbrochen sind, wobei der Belüftungsstromkreis (54) in den Schaltstellungen 1 bis 3, und insbesondere in der Schaltstellung 4, unterbrochen ist.

4. Niederdruckplasmaanlage nach einem der Ansprüche 1 bis 3, bei der die Steuerung (32) einen Druckmessstromkreis (40) mit einem Druckmessgerät (70) umfasst, wobei das sequentielle Schaltelement (30) zum Unterbrechen und Schließen des Druckmessstromkreises (40) ausgebildet ist, wobei der Druckmessstromkreis (40) in den Schaltstellungen 1 bis 3, sowie insbesondere den Schaltstellungen 4 und/oder 5, geschlossen ist.

5. Niederdruckplasmaanlage nach Anspruch 4, bei der das Druckmessgerät (70) dazu ausgebildet ist, ein erstes Freigabesignal an das Gaszuflussventil (20) zu dessen Freigabe und/oder an den Plasmagenerator (78) zu dessen Freigabe zu übermitteln.

6. Niederdruckplasmaanlage nach einem der Ansprüche 1 bis 5, bei der die Steuerung (32) einen Timerstromkreis (44) mit einem Timer (76) umfasst, wobei das sequentielle Schaltelement (30) zum Unterbrechen und Schließen des Timerstromkreises (44) ausgebildet ist, wobei der Timerstromkreis (44) in der Schaltstellung 3 geschlossen ist.

7. Niederdruckplasmaanlage nach Anspruch 6, bei der der Timer (76) dazu ausgebildet ist, ein zweites Freigabesignal an den Plasmagenerator (78) zu dessen Freigabe zu übermitteln.

8. Niederdruckplasmaanlage nach einem der Ansprüche 1 bis 7, bei der die Steuerung (32) einen Heizungsstromkreis (48) mit einer Heizung (72) umfasst, wobei das sequentielle Schaltelement (30) zum Unterbrechen und Schließen des Heizungsstromkreises (48) ausgebildet ist, wobei der Heizungsstromkreis (48) in der Schaltstellung 3 geschlossen ist.

9. Niederdruckplasmaanlage nach Anspruch 8, bei der die Steuerung (32) einen Temperaturmessstromkreis (50) mit einem Temperaturmesselement (74) umfasst, wobei das sequentielle Schaltelement (30) zum Unterbrechen und Schließen des Temperaturmessstromkreises (50) ausgebildet ist, wobei der Temperaturmessstromkreis (50) in der Schaltstellung 3 geschlossen ist.

10. Niederdruckplasmaanlage nach einem der Ansprüche 1 bis 9, bei der die Steuerung (32) einen Netzteilstromkreis (36) mit einem Netzteil (68) umfasst, wobei das sequentielle Schaltelement (30) zum Unterbrechen und Schließen des Netzteilstromkreises (36) ausgebildet ist, wobei der Netzteilstromkreis (36) in den Schaltstellungen 1 bis 3, sowie insbesondere in den Schaltstellungen 4 und/oder 5, geschlossen ist.

11. Niederdruckplasmaanlage nach einem der Ansprüche 1 bis 10, bei der die Steuerung (32) einen Pumpenstromkreis (34) mit einem Pumpennetzteil umfasst, wobei das sequentielle Schaltelement (30) zum Unterbrechen und Schließen des Pumpenstromkreises (34) ausgebildet ist, wobei der Pumpenstromkreis (34) in den Schaltstellungen 1 bis 3, sowie insbesondere in den Schaltstellungen 4 und/oder 5, geschlossen ist.

12. Niederdruckplasmaanlage nach einem der Ansprüche 1 bis 11, bei der die Steuerung (32) einen Sicherheitsstromkreis mit einem Sicherheitsschalter, insbesondere einem Türschalter der Behandlungskammer, umfasst, wobei das sequentielle Schaltelement (30) zum Unterbrechen und Schließen des Sicherheitsstromkreises ausgebildet ist, wobei der Sicherheitsstromkreis in den Schaltstellungen 1 bis 3, sowie insbesondere in den Schaltstellungen 4 und/oder 5, geschlossen ist.

13. Niederdruckplasmaanlage nach einem der Ansprüche 1 bis 12, bei der der Vakuumstromkreis (38), der Gaszuflussstromkreis (42) und /oder der Plasmastromkreis (46) eine Lampe, insbesondere eine Leuchtdiode, zur Darstellung des jeweiligen Prozessschrittes aufweist.

14. Niederdruckplasmaanlage nach einem der Ansprüche 1 bis 13, bei der das sequentielle Schaltelement (30) eine nullte Schaltstellung aufweist, in der alle Stromkreise (34, 36, 38, 40, 42, 44, 46, 48, 50, 52, 54) der Steuerung (32) unterbrochen sind.

15. Niederdruckplasmaanlage nach einem der Ansprüche 1 bis 14, bei der das sequentielle Schaltelement (30) in Form eines, insbesondere sechsstufigen, Drehschalters ausgebildet ist.

## Claims

1. Low-pressure plasma system (10) comprising an at least partially evacuable treatment chamber (12), a gas inflow valve (20), a plasma generator (78) and a controller (32), wherein the controller (32) comprises a vacuum circuit (38), a gas inflow circuit (42) and a plasma circuit (46), wherein the vacuum circuit (38) controls a pump (14), which can be connected to the low-pressure plasma system (10), and/or a pump valve (38) of the low-pressure plasma system (10), the gas inflow circuit (42) controls the gas inflow valve (20) and the plasma circuit (46) controls the plasma generator (78), wherein the controller (32) comprises a sequential switch element (30) having successive switch positions for setting successive process steps, wherein the sequential switch element (30) in each switch position is formed by a plurality of electrically isolated switches (56, 58, 60, 62, 64, 66) in order to respectively interrupt and close the vacuum circuit (38), the gas inflow circuit (42) and the plasma circuit (46), wherein the sequential switch element (30) has a first switch position in which the vacuum circuit (38) is closed but the gas inflow circuit (42) and the plasma circuit (46) are interrupted, wherein the sequential switch element (30) has a second switch position in which the vacuum circuit (38) and the gas inflow circuit (42) are closed but the plasma circuit (46) is interrupted, wherein the sequential switch element (30) has a third switch position in which the vacuum circuit (38), the gas inflow circuit (42) and the plasma circuit (46) are closed, wherein the sequential switch element (30) has a plurality of switches (56, 58, 60, 62, 64, 66) for controlling the vacuum circuit (38), the gas inflow circuit (42) and the plasma circuit (46) in each case, which switches can be successively opened and closed, and wherein the sequential switch element (30) is designed to close a plurality of electrically isolated switches (56, 58, 60, 62, 64, 66) of the sequential switch element (30) in each switch position.

2. Low-pressure plasma system according to claim 1, in which the controller (32) comprises a flushing circuit (52) which has a flushing valve (28), wherein the sequential switch element (30) is designed to interrupt and close the flushing circuit (52), wherein the sequential switch element (30) has a fourth switch position in which the vacuum circuit (38) and the flushing circuit (52) are closed but the gas inflow circuit (42) and the plasma circuit (46) are interrupted, wherein the flushing circuit (52) is interrupted in switch positions 1 to 3.

3. Low-pressure plasma system according to either claim 1 or claim 2, in which the controller (32) comprises a ventilation circuit (54) which has a ventilation valve (18), wherein the sequential switch element (30) is designed to interrupt and close the ventilation circuit (54), wherein the sequential switch element (30) has a fifth switch position in which the ventilation circuit (54) is closed but the vacuum circuit (38), the gas inflow circuit (42) and the plasma circuit (46) are interrupted, wherein the ventilation circuit (54) is interrupted in switch positions 1 to 3, and in particular in switch position 4.

4. Low-pressure plasma system according to any of claims 1 to 3, in which the controller (32) comprises a pressure measuring circuit (40) which has a pressure measuring device (70), wherein the sequential switch element (30) is designed to interrupt and close the pressure measuring circuit (40), wherein the pressure measuring circuit (40) is closed in switch positions 1 to 3, and in particular in switch positions 4 and/or 5.

5. Low-pressure plasma system according to claim 4, in which the pressure measuring device (70) is designed to transmit a first enabling signal to the gas inflow valve (20) for the purpose of enabling said valve and/or to the plasma generator (78) for the purpose of enabling said generator.

6. Low-pressure plasma system according to any of claims 1 to 5, in which the controller (32) comprises a timer circuit (44) which has a timer (76), wherein the sequential switch element (30) is designed to interrupt and close the timer circuit (44), wherein the timer circuit (44) is closed in switch position 3.

7. Low-pressure plasma system according to claim 6, in which the timer (76) is designed to transmit a second enabling signal to the plasma generator (78) for the purpose of enabling said generator.

8. Low-pressure plasma system according to any of claims 1 to 7, in which the controller (32) comprises a heating circuit (48) which has a heater (72), wherein the sequential switch element (30) is designed to interrupt and close the heating circuit (48), wherein the heating circuit (48) is closed in switch position 3.

9. Low-pressure plasma system according to claim 8, in which the controller (32) comprises a temperature measuring circuit (50) which has a temperature measuring element (74), wherein the sequential switch element (30) is designed to interrupt and close the temperature measuring circuit (50), wherein the temperature measuring circuit (50) is closed in switch position 3.

10. Low-pressure plasma system according to any of claims 1 to 9, in which the controller (32) comprises a power supply circuit (36) which has a power supply (68), wherein the sequential switch element (30) is designed to interrupt and close the power supply circuit (36), wherein the power supply circuit (36) is closed in switch positions 1 to 3, and in particular in switch positions 4 and/or 5.

11. Low-pressure plasma system according to any of claims 1 to 10, in which the controller (32) comprises a pump circuit (34) which has a pump power supply, wherein the sequential switch element (30) is designed to interrupt and close the pump circuit (34), wherein the pump circuit (34) is closed in switch positions 1 to 3, and in particular in switch positions 4 and/or 5.

12. Low-pressure plasma system according to any of claims 1 to 11, in which the controller (32) comprises a safety circuit which has a safety switch, in particular a door switch of the treatment chamber, wherein the sequential switch element (30) is designed to interrupt and close the safety circuit, wherein the safety circuit is closed in switch positions 1 to 3, and in particular in switch positions 4 and/or 5.

13. Low-pressure plasma system according to any of claims 1 to 12, in which the vacuum circuit (38), the gas inflow circuit (42) and/or the plasma circuit (46) has a lamp, in particular a light-emitting diode, for the purpose of indicating the relevant process step.

14. Low-pressure plasma system according to any of claims 1 to 13, in which the sequential switch element (30) has a zeroth switch position in which all circuits (34, 36, 38, 40, 42, 44, 46, 48, 50, 52, 54) of the controller (32) are interrupted.

15. Low-pressure plasma system according to any of claims 1 to 14, in which the sequential switch element (30) is in the form of a rotary switch, in particular a six-stage rotary switch.

## Revendications

1. Installation à plasma basse pression (10) comportant une chambre de traitement (12) pouvant être mise au vide au moins partiellement, une soupape d'arrivée de gaz (20), un générateur de plasma (78) et une commande (32),
dans laquelle la commande (32) comprend un circuit de vide (38), un circuit d'arrivée de gaz (42) et un circuit de plasma (46),
dans laquelle le circuit de vide (38) commande une pompe (14) pouvant être raccordée à l'installation à plasma basse pression (10) et/ou une soupape de pompe (38) de l'installation à plasma basse pression (10), le circuit d'arrivée de gaz (42) commande la soupape d'arrivée de gaz (20) et le circuit de plasma (46) le générateur de plasma (78),
dans laquelle la commande (32) comprend un élément de commutation séquentielle (30) ayant des positions de commutation successives pour régler des étapes de processus successives,
dans laquelle l'élément de commutation séquentielle (30) est formé, dans chaque position de commutation, par plusieurs commutateurs (56, 58, 60, 62, 64, 66) électriquement isolés les uns des autres pour respectivement interrompre et fermer le circuit de vide (38), le circuit d'arrivée de gaz (42) et le circuit de plasma (46),
dans laquelle l'élément de commutation séquentielle (30) présente une première position de commutation dans laquelle le circuit de vide (38) est fermé mais le circuit d'arrivée de gaz (42) et le circuit de plasma (46) sont interrompus,
dans laquelle l'élément de commutation séquentielle (30) présente une deuxième position de commutation dans laquelle le circuit de vide (38) et le circuit d'arrivée de gaz (42) sont fermés mais le circuit de plasma (46) est interrompu, dans laquelle l'élément de commutation séquentielle (30) présente une troisième position de commutation dans laquelle le circuit de vide (38), le circuit d'arrivée de gaz (42) et le circuit de plasma (46) sont fermés,
dans laquelle l'élément de commutation séquentielle (30) présente, pour commander le circuit de vide (38), le circuit d'arrivée de gaz (42) et le circuit de plasma (46), chaque fois plusieurs commutateurs (56, 58, 60, 62, 64, 66) qui peuvent être ouverts et fermés successivement, et dans laquelle l'élément de commutation séquentielle (30) est réalisé pour, dans chaque position de commutation, fermer une pluralité de commutateurs (56, 58, 60, 62, 64, 66) électriquement isolés les uns des autres de l'élément de commutation séquentielle (30).

2. Installation à plasma basse pression selon la revendication 1, dans laquelle la commande (32) comprend un circuit de rinçage (52) avec une soupape de rinçage (28), l'élément de commutation séquentielle (30) étant réalisé pour interrompre et fermer le circuit de rinçage (52),
dans laquelle l'élément de commutation séquentielle (30) présente une quatrième position de commutation dans laquelle le circuit de vide (38) et le circuit de rinçage (52) sont fermés, mais le circuit d'arrivée de gaz (42) et le circuit de plasma (46) sont interrompus, le circuit de rinçage (52) étant interrompu dans les positions de commutation 1 à 3.

3. Installation à plasma basse pression selon la revendication 1 ou 2, dans laquelle la commande (32) comprend un circuit de ventilation (54) avec une soupape de ventilation (18), l'élément de commutation séquentielle (30) étant réalisé pour interrompre et fermer le circuit de ventilation (54),
dans laquelle l'élément de commutation séquentielle (30) présente une cinquième position de commutation, dans laquelle le circuit de ventilation (54) est fermé, mais le circuit de vide (38), le circuit d'arrivée de gaz (42) et le circuit de plasma (46) sont interrompus, le circuit de ventilation (54) étant interrompu dans les positions de commutation 1 à 3 et, en particulier, dans la position de commutation 4.

4. Installation à plasma basse pression selon l'une des revendications 1 à 3, dans laquelle la commande (32) comprend un circuit de mesure de pression (40) avec un dispositif de mesure de pression (70), l'élément de commutation séquentielle (30) étant réalisé pour interrompre et fermer le circuit de mesure de pression (40), le circuit de mesure de pression (40) étant fermé dans les positions de commutation 1 à 3 et, en particulier, dans les positions de commutation 4 et/ou 5.

5. Installation à plasma basse pression selon la revendication 4, dans laquelle le dispositif de mesure de pression (70) est réalisé pour transmettre un premier signal de validation à la soupape d'arrivée de gaz (20) pour sa validation et/ou au générateur de plasma (78) pour sa validation.

6. Installation à plasma basse pression selon l'une des revendications 1 à 5, dans laquelle la commande (32) comprend un circuit de minuterie (44) avec une minuterie (76), l'élément de commutation séquentielle (30) étant réalisé pour interrompre et fermer le circuit de minuterie (44), le circuit de minuterie (44) étant fermé dans la position de commutation 3.

7. Installation à plasma basse pression selon la revendication 6, dans laquelle la minuterie (76) est réalisée pour transmettre un deuxième signal de validation au générateur de plasma (78) pour sa validation.

8. Installation à plasma basse pression selon l'une des revendications 1 à 7, dans laquelle la commande (32) comprend un circuit de chauffage (48) avec un élément chauffant (72), l'élément de commutation séquentielle (30) étant réalisé pour interrompre et fermer le circuit de chauffage (48), le circuit de chauffage (48) étant fermé dans la position de commutation 3.

9. Installation à plasma basse pression selon la revendication 8, dans laquelle la commande (32) comprend un circuit de mesure de température (50) avec un élément de mesure de température (74), l'élément de commutation séquentielle (30) étant réalisé pour interrompre et fermer le circuit de mesure de température (50), le circuit de mesure de température (50) étant fermé dans la position de commutation 3.

10. Installation à plasma basse pression selon l'une des revendications 1 à 9, dans laquelle la commande (32) comprend un circuit d'alimentation électrique (36) avec une alimentation électrique (68), l'élément de commutation séquentielle (30) étant réalisé pour interrompre et fermer le circuit d'alimentation électrique (36), le circuit d'alimentation électrique (36) étant fermé dans les positions de commutation 1 à 3 et, en particulier, dans les positions de commutation 4 et/ou 5.

11. Installation à plasma basse pression selon l'une des revendications 1 à 10, dans laquelle la commande (32) comprend un circuit de pompe (34) avec une alimentation électrique de pompe, l'élément de commutation séquentielle (30) étant réalisé pour interrompre et fermer le circuit de pompe (34), le circuit de pompe (34) étant fermé dans les positions de commutation 1 à 3 et, en particulier, dans les positions de commutation 4 et/ou 5.

12. Installation à plasma basse pression selon l'une des revendications 1 à 11, dans laquelle la commande (32) comprend un circuit de sécurité avec un interrupteur de sécurité, en particulier un interrupteur de porte de la chambre de traitement, l'élément de commutation séquentielle (30) étant réalisé pour interrompre et fermer le circuit de sécurité, le circuit de sécurité étant fermé dans les positions de commutation 1 à 3 et, en particulier, dans les positions de commutation 4 et/ou 5.

13. Installation à plasma basse pression selon l'une des revendications 1 à 12, dans laquelle le circuit de vide (38), le circuit d'arrivée de gaz (42) et/ou le circuit de plasma (46) présente une lampe, en particulier une diode électroluminescente, pour représenter l'étape de processus respective.

14. Installation à plasma basse pression selon l'une des revendications 1 à 13, dans laquelle l'élément de commutation séquentielle (30) présente une position de commutation zéro dans laquelle tous les circuits (34, 36, 38, 40, 42, 44, 46, 48, 50, 52, 54) de la commande (32) sont interrompus.

15. Installation à plasma basse pression selon l'une des revendications 1 à 14, dans laquelle l'élément de commutation séquentielle (30) se présente sous la forme d'un commutateur rotatif, en particulier à six positions.
